# EUROPEAN PATENT SPECIFICATION

(11) **EP 2 197 256 B1**
(45) Date of publication and mention of the grant of the patent: **17.08.2011**
(21) Application number: 08291163.7
(22) Date of filing: 10.12.2008
(51) Int. Cl.: H05K 7/20, H05K 7/14

(54) **Cooling device with vortex generators embedded in a board guide rail plate**
Kühlvorrichtung mit Wirbelerzeugern, die in eine Leiterplattenführungsschienenplatte integriert ist
Dispositif de refroidissement doté de générateurs de vortex intégrés dans une plaque de rail guide de carte

(43) Date of publication of application: 16.06.2010
(73) Proprietor: Alcatel Lucent, 75008 Paris (FR)
(72) Inventor: Joncourt, Christian, 22300 Lannion (FR); Odabachian, Robin, 22560 Trébeurden (FR); Hernon, Domhnaill, Bettystown (IE)
(74) Representative: Narmon, Gisèle Marie Thérèse

(56) References cited:
- EP-A- 0 470 926
- DE-A1-102004 054 338
- US-A- 5 304 845
- US-B1- 6 493 235

## Description

The present invention relates to a cooling device for a telecommunication system with a board guide rail plate whereof each guide rail is adapted to receive an edge of a printed circuit board.

Such a cooling device is generally known in the art. A printed circuit board of a telecommunication system may dissipate greater than 300W with more than 50% of this power concentrated on only a couple of devices.

The standard cooling solution in Telecom applications is to thermally connect metal heat sinks to the heat generating components and to pass airflow over these heat sinks via many fans. This is for instance applied to the next generation of Advanced Telecom Computing Architecture ATCA board. Advanced TCA or ATCA is a family of industry standards that define new blade (board) and chassis form factor (shelf) optimized for communications. ATCA is being developed by the PCI Industrial Computer Manufacturers Group PCIMG and is designed to meet the requirements of next-generation communication applications that cannot be served by existing solutions such as CompactPCI™, proprietary or IT server based solutions.

There are number of technical problems with this known solution, especially as the heat loads and densities encountered in Telecom applications are ever increasing. Providing adequate airflow to cool the components is posing a real problem considering the increasing thermal loads and densities. The reason for this difficulty is due to noise limitations of 65 dBa in the Central Office CO environment which implies that the fans can not operate at higher power (or at higher airflow rate) as the fans are the main source of noise in the Central Office. In addition, there are reliability issues with fans when they operate at maximum power and at high temperatures. It is known that fans are one of the most unreliable components in our equipment.

The best existing solution to the problem is to attach a heat sink to the hot component and then pass airflow over this via many fans.

The current solution is not adequately cooling the hot components even with pure copper heat sinks embedded with heat pipes in the heat sink base. Furthermore, in order to supply adequate cooling the fans must be operated at increased power. Operating the fans like this reduces the fan reliability, increases the acoustic noise above the regulated levels and also increases customer OpEx.

All of this implies that providing adequate cooling to the hottest components is expensive and proving to be very difficult.

As forced convection is used for heat removal, a compromise is necessary between air flow rate, heat sink size and board density. Therefore, any enhancement in heat transfer makes this compromise easier.

An object of the present invention is to provide a cooling device of the above known type but wherein heat transfer is improved.

According to the invention, this object is achieved due to the fact that said cooling device comprises at least one vortex generator provided at a guide rail of said board guide rail plate, and that said vortex generator comprises a wing embedded on said guide rail.

In this way, by adding one or more vortex generators into the fluid flow the heat transfer is considerably improved, thereby reducing the heat sink thermal resistance for little extra cost and without large pressure drop penalties.

Although any vortex generator creates unsteady flow, the present vortex generator preferably has the form of a wing that enhances heat transfer by increasing the mixing between fluid streams and thinning the boundary layers in which the vortices come into contact with.

The main advantage of the present solution is that the vortex generators are implemented in the guide rail of the board guide rail plate, e.g. in the ATCA shelf board guide plate thickness, so it has no impact on board layout and routing.

It is to be noted that the European Patent Application EP-A-0 470 926 (SULZER AG [CH]) published on 12 February 1992 and entitled "Luftkühlung von mit Leiterplatten bestückten Steuerschränken" also discloses a cooling device of the above type.

Moreover, also the German Patent Application DE 10 2004 054338 A1 (RITUAL RES Electronic Systems [DE]) published on 18 May 2006 and entitled "Kopf- oder Bodenteil eines Baugruppenträgers" discloses a similar cooling device.

However, in these two known prior art documents, nothing indicates nor teaches that the vortex generator (or equivalent item) is or should be provided at the guide rail itself rather than on the board guide rail plate and that the wing thereof is embedded in this guide rail, as characterizes the present invention.

Also another characterizing embodiment of the present invention is that the surface of said wing is in a plan different from that of said printed circuit board.

The surface of the wing may be more or less orthogonal to the plan of the board or forming an angle of about 135° therewith in order to achieve an optimal creation of unsteady fluid flow.

In a preferred characterizing embodiment of the present invention, the surface of a first wing embedded on said guide rail is in a plan different from that of the surface of a second wing also embedded on said guide rail.

By having different wings in different plans, the cooling may be even more improved when a flow of fluid is propelled thereon.

Yet another characterizing embodiment of the present invention is that said first wing is attached at one longitudinal side of said guide rail and said second wing is attached at the opposite longitudinal side of said guide rail.

Placing vortex generators at both sides of a guide rail allows providing better cooling.

The present vortex generator utilizes for enhanced air cooling a part of the Telecom equipment that has previously not been using.

Yet another characterizing embodiment of the present invention is that said wing has a delta wing design shape.

An optimal choice of the shape of the vortex generator allows optimizing the cooling capacity of the existing forced convection airflow rate.

Further characterizing embodiments of the present cooling device are mentioned in the appended claims.

It is to be noticed that the term `comprising', used in the claims, should not be interpreted as being restricted to the means listed thereafter. Thus, the scope of the expression 'a device comprising means A and B' should not be limited to devices consisting only of components A and B. It means that with respect to the present invention, the only relevant components of the device are A and B.

Similarly, it is to be noticed that the term 'coupled', also used in the claims, should not be interpreted as being restricted to direct connections only. Thus, the scope of the expression 'a device A coupled to a device B' should not be limited to devices or systems wherein an output of device A is directly connected to an input of device B. It means that there exists a path between an output of A and an input of B which may be a path including other devices or means.

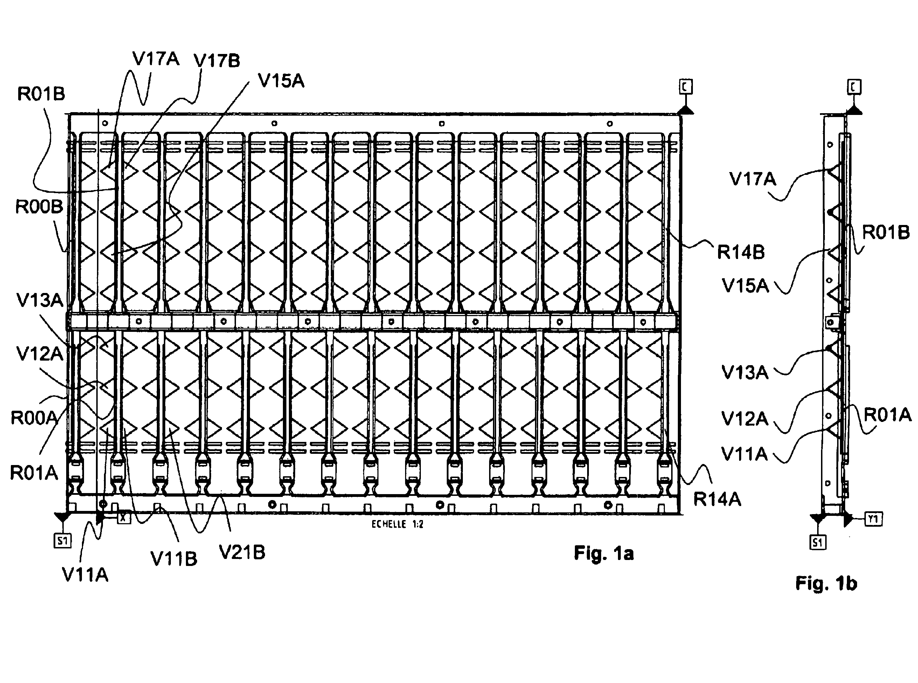

The above and other objects and features of the invention will become more apparent and the invention itself will be best understood by referring to the following description of an embodiment taken in conjunction with the accompanying drawing wherein the figure shows a top view (Fig. 1a) and a side view (Fig. 1b) of a cooling device with vortex generators embedded in guide rails a board guide rail plate according to the invention.

The top view of a board guide rail plate of a telecommunication system is shown at Fig. 1a. This board guide rail plate is provided with, e.g. 15, guide rails such as R00A/R00B, R01A/R01B, ..., R14A/R14B whereon an edge of a printed circuit board may be engaged by sliding. The guide rails enable the easy introduction of cards or boards into the slots.

In the figure, each guide rail is constituted by two parts respectively labeled with an extension A and B, e.g. R01A and R01B, and longitudinally aligned in order to receive a same board. A side view of the board guide rail plate, showing one side of the guide rail R01A/R01B is represented at Fig. 1b.

Board guide rails are ubiquitous in telecommunication equipment and they are currently under utilized. In the present application, guide rails are provided with embedded wings operating as vortex generators for any fluid flow, e.g. airflow, propelled thereon in the direction of the board, i.e. from bottom to top. The wings or the vortex generators constitute a cooling device for the telecommunication system.

The figure shows a vortex generator assembly wherein the board guide rail plate assembly has one vortex generator basic element fixed on each of the board rail. Each vortex generator basic element is constituted by one or more wings V11A - V17A; V11B - V17B.

In more detail, the guide rail R01A/R01B has its first portion R01A provided with embedded vortex generators V11A, V12A, V13A; V11B, ..., V13B, whilst its second portion R01B is provided with embedded vortex generators V14A, V15A, ..., V17A; V14B, ..., V17B. The vortex generators labeled with an extension A being located at the left and those labeled with an extension B at the right of the guide rail with respect to Fig. 1a.

In this example of configuration, and although not always necessary, the vortex generators V11A - V17A; V11B - V17B are provided at both sides of the guide rail R01A/R01B. The vortex generators, implemented in the shelf board guide plate thickness, are thus located in the region between two adjacent guide rails R00A/R00B, R01A/R01B and have thereby no impact on board layout and routing.

Vortex generators create unsteady flow that enhances heat transfer by increasing the mixing between fluid streams and thinning the boundary layers in which the vortices come into contact with.

Because the vortex generators are placed on the guide rail upstream of the board, the airflow generated by fans passes over the vortex generators from the bottom to the top thereby generating unsteady vertical flow that enhances the heat transfer of the board components placed downstream.

For the purposes of an Advanced Telecom Computing Architecture ATCA application, the vortex generators have here been placed specifically on the board guide rail. However, it is to be noted that the vortex generators could also be placed at other locations such as at the inlet of the slot on the circuit board itself.

The shape of the multiple wings or vortex generators attached at the longitudinal sides of the guide rail may be different. The guide rail R01A/R01B may for instance preferably comprise two rows of delta wing vortex generators.

The delta wing configuration has been chosen because it is best suited for the present application. However, the shape of the wings V11A - V17A; V11B - V17B should not be limited only to the delta wing design. Any shape structure that generates unsteady flow or vortices may be used in place. For example: cylinders, cubes, delta winglets, etc.

Furthermore, the surface of the wings V11A - V17A; V11B - V17B is in a plan different from that of the printed circuit board.

With the goal of achieving an optimal creation of unsteady fluid flow, the surface of the wings may be oriented to be more or less orthogonal to the plan of the board or forming an angle of about 135° therewith.

Any wing may be oriented differently in any directions so as to create an adapted airflow

The introduction of such vortex generators on the board guide rails improves heat transfer on the existing board which in turn improves component reliability because of the optimal or adapted airflow.

The introduction of vortex generators on the board guide rails also improve the acoustic noise and fan power consumption owing to the fact that with enhanced heat transfer there is no longer the same demand on the fans.

A final remark is that embodiments of the present invention are described above in terms of functional blocks. From the functional description of these blocks, given above, it will be apparent for a person skilled in the art of designing electronic devices how embodiments of these blocks can be manufactured with well-known electronic components. A detailed architecture of the contents of the functional blocks hence is not given.

While the principles of the invention have been described above in connection with specific apparatus, it is to be clearly understood that this description is merely made by way of example and not as a limitation on the scope of the invention, as defined in the appended claims.

## Claims

1. A cooling device for a telecommunication system with a board guide rail plate whereof each guide rail (R00A/R00B; R01A/R01B; R14A/R14B) is adapted to receive an edge of a printed circuit board,
***characterized in that*** said cooling device comprises at least one vortex generator (V11A - V17A; V11B - V17B) provided at a guide rail (R01A/R01B) of said board guide rail plate,
*and **in that*** said vortex generator comprises a wing (V11A - V17A; V11B - V17B) embedded on said guide rail (R01A/R01B).

2. The cooling device according to claim 1, ***characterized in that*** vortex generators (V11A - V17A; V11B - V17B) are provided at both sides of said guide rail (R01A/R01B).

3. The cooling device according to claim 1, ***characterized in that*** the surface of said wing (V11A - V17A; V11B - V17B) is in a plan different from that of said printed circuit board.

4. The cooling device according to claim 3, ***characterized in that*** the surface of a first wing (V11A - V17A) embedded on said guide rail (R01A/R01B) is in a plan different from that of the surface of a second wing (V11B - V17B) also embedded on said guide rail.

5. The cooling device according to claim 4, ***characterized in that*** said first wing has a shape different from that of said second wing.

6. The cooling device according to the claims 2 and 4, ***characterized in that*** said first wing (V11A - V17A) is attached at one longitudinal side of said guide rail and said second wing (V11B - V17B) is attached at the opposite longitudinal side of said guide rail (R01A/R01B).

7. The cooling device according to claim 1, ***characterized in that*** said wing (V11A - V17A; V11B - V17B) has any shape structure that generates unsteady flow or vortices.

## Patentansprüche

1. Kühlvorrichtung für ein Telekommunikationssystem mit einer Leiterplattenführungsschienenplatte, wobei jede Führungsschiene (R00A/R00B; R01A/R01 B; R14A/R14B) für die Aufnahme einer Randkante einer Leiterplatte geeignet ist,
***dadurch gekennzeichnet, dass*** die besagte Kühlvorrichtung mindestens einen Wirbelerzeuger (V11A - V17A; V11B - V17B) umfasst, welcher an einer Führungsschiene (R01A/R01B) der besagten Leiterplattenführungsschienenplatte angeordnet ist,
*und dass* der besagte Wirbelerzeuger (V11A - V17A; V11B - V17B) einen in der besagten Führungsschiene (R01A/R01 B) integrierten Flügel aufweist.

2. Die Kühlvorrichtung nach Anspruch 1, ***dadurch gekennzeichnet, dass*** an beiden Seiten der besagten Führungsschiene (R01A/R01B) Wirbelerzeuger (V11A - V17A; V11B - V17B) angeordnet sind.

3. Die Kühlvorrichtung nach Anspruch 1, ***dadurch gekennzeichnet, dass*** die Oberfläche des besagten Flügels (V11A - V17A; V11B - V17B) in einer anderen Ebene ausgerichtet ist als die besagte Leiterplatte.

4. Die Kühlvorrichtung nach Anspruch 3, ***dadurch gekennzeichnet, dass*** die Oberfläche eines auf der besagten Führungsschiene (R01A/R01B) integrierten ersten Flügels (V11A - V17A) in einer anderen Ebene ausgerichtet ist als die Oberfläche eines ebenfalls auf der besagten Führungsschiene (R01A/R01B) integrierten zweiten Flügels (V11B-V17B).

5. Die Kühlvorrichtung nach Anspruch 4, ***dadurch gekennzeichnet, dass*** der besagte erste Flügel eine andere Form aufweist als der besagte zweite Flügel.

6. Die Kühlvorrichtung nach einem der Ansprüche 2 und 4, ***dadurch gekennzeichnet, dass*** der besagte erste Flügel (V11A - V17A) an einer Längsseite der besagten Führungsschiene befestigt ist, und der besagte zweite Flügel (V11B - V17B) an der gegenüberliegenden Längsseite der besagten Führungsschiene (R01A/R01 B) befestigt ist.

7. Die Kühlvorrichtung nach Anspruch 1, ***dadurch gekennzeichnet, dass*** der besagte Flügel (V11A - V17A; V11B - V17B) eine beliebige Formstruktur aufweist, welche unregelmäßige Flüsse oder Wirbel erzeugt.

## Revendications

1. Dispositif de refroidissement pour un système de télécommunication comprenant une plaque à glissière de carte, chaque glissière (R00A/R00B ; R01A/R01B; R14A/R14B) étant adaptée pour recevoir un bord d'un circuit imprimé,
***caractérisé en ce que*** ledit dispositif de refroidissement comprend au moins un générateur de vortex (V11A - V17A ; V11B - V17B) réalisé sous la forme d'une glissière (R01A/R01B) de ladite plaque à glissière,
*et **en ce que*** ledit générateur de vortex comprend une aile (V11A - V17A ; V11B - V17B) intégrée sur ladite glissière (R01A/R01B).

2. Dispositif de refroidissement selon la revendication 1, ***caractérisé en ce que*** des générateurs de vortex (V11A - V17A; V11B - V17B) sont prévus des deux côtés de ladite glissière (R01A/R01B).

3. Dispositif de refroidissement selon la revendication 1, ***caractérisé en ce que*** la surface de ladite aile (V11A - V17A ; V11 B - V17B) se trouve dans un plan différent de celui dudit circuit imprimé.

4. Dispositif de refroidissement selon la revendication *3, **caractérisé en ce que*** la surface d'une première aile (V11A - V17A) intégrée sur ladite glissière (R01A/R01 B) se trouve dans un plan différent de celui de la surface d'une deuxième aile (V11B - V17B) elle aussi intégrée sur ladite glissière.

5. Dispositif de refroidissement selon la revendication *4, **caractérisé en ce que*** ladite première aile a une forme différente de celle de ladite deuxième aile.

6. Dispositif de refroidissement selon les revendications *2 et 4, **caractérisé en ce que*** ladite première aile (V11A - V17A) est fixée sur un côté longitudinal de ladite glissière et ladite deuxième aile (V11B - V17B) est fixée sur le côté longitudinal opposé de ladite glissière (R01A/R01B).

7. Dispositif de refroidissement selon la revendication 1, ***caractérisé en ce que*** ladite aile (V11A - V17A; V11B - V17B) présente une structure de forme quelconque qui génère un flux instable de plusieurs vortex.
